# EUROPEAN PATENT APPLICATION

(11) **EP 1 231 301 A1**
(43) Date of publication of application: **14.08.2002**
(21) Application number: 00939172.3
(22) Date of filing: 26.06.2000
(51) Int. Cl.: C30B 29/06

(54) **EPITAXIAL SILICON WAFER**

(30) Priority: 27.08.1999 JP 24118799
(71) Applicant: Komatsu Denshi Kinzoku Kabushiki Kaisha, Hiratsukashi, Kanagawa 254-0014 (JP)
(72) Inventor: KOMIYA, Satoshi Komatsu Denshi Kinzoku KK, Hiratsuka-shi, Kanagawa 254-0014 (JP); YOSHINO, Shiro, Komatsu Kinzouku Denshi KK, Hiratsuka-shi, Kanagawa 254-0014 (JP); DANBATA, Masayoshi, Komatsu Denshi Kinzoku KK, Hiratsuka-shi, Kanagawa 254-0014 (JP); HAYASHIDA, Kouichirou, Komatsu Denshi KK, Hiratsuka-shi, Kanagawa 254-0014 (JP)
(74) Representative: Ganahl, Bernhard
(86) International application number: JP0004216
(87) International publication number: WO0116408

(57) **Abstract**

An epitaxial silicon wafer which comprises a silicon wafer produced by a method characterized as comprising pulling up a silicon single crystal under a condition wherein when an oxygen concentration is 7 x 10¹⁷ atoms/cm³ a nitrogen concentration is about 3 x 10¹⁵ atoms/cm³ or less, and when an oxygen concentration is 1.6 x 10¹⁸ atoms/cm³ a nitrogen concentration is about 3 x 10¹⁴ atoms/cm³ or less, and, an epitaxial film formed on the wafer. The epitaxial film, being formed on such a wafer, has crystal defects, which are observed as LPD of 120 nm or more on the epitaxial film, in a range of 20 pieces/200-mm wafer or less. The epitaxial silicon wafer contains nitrogen atoms doped therein and also has satisfactory characteristics as that for use in a semiconductor device.

## Description

### TECHNICAL FIELD

The present invention relates to epitaxial silicon wafers and in particular to epitaxial silicon wafers wherein epitaxial growth is performed on a nitrogen-doped silicon wafer.

### BACKGROUND ART

With a substrate of ordinary resistance (silicon wafer substrate) where epitaxial process is performed, device production yield is dropped due to a lowered gettering ability caused by delay in precipitation that results from a loss of oxygen precipitation nuclei of below the critical size during the initial high temperature process in the epitaxial step.

Counter-measures that have been proposed in respect of this problem include the method of growing the precipitates beforehand by performing heat treatment prior to the epitaxial process and the method of forming a polysilicon layer on the back face of the substrate to provide gettering sites. However, these methods had the problem of increased costs owing to the considerable time and labour which they involve, which severely adversely affects the productivity of the product.

Under such circumstances, study has been made in which nitrogen is doped into a silicon single crystal in order to obtain gettering ability, based on the knowledge that nitrogen doping during the growing of a single crystal by the Czochralski method (CZ method) contributes to promoting for oxygen precipitation.

However, the nitrogen doping will make larger oxygen precipitates after single crystal growth by the CZ method. Therefore, a nitrogen-doped silicon wafer was unsuitable as a silicon wafer substrate to be supplied for use in epitaxial growth.

In practice, the method where nitrogen doping is performed does not involve large increase in costs. However, it is necessary to ensure a device active layer (i.e. DZ layer in the vicinity of the wafer surface layer), and to pay close attention to the control of the bulk gettering sites. This is also true in case of epitaxial substrates. Particularly, if oxygen precipitates are present in the surface layer of the silicon wafer substrate, these provide starting points for development of epitaxial growth abnormalities, which result in defects of the epitaxial surface layer that deteriorate the performance of the device.

### DISCLOSURE OF THE INVENTION

In view of the foregoing problems, an object of the present invention is to provide an epitaxial silicon wafer having fully satisfactory properties for use in forefront of semiconductor devices, by discovering the conditions for a nitrogen-doped silicon wafer substrate that produces no defects in the epitaxial surface layer that worsen device properties.

As a result of meticulous investigations aimed at achieving the above object, the inventors of the present application discovered that defects of the epitaxial surface layer that adversely affect device characteristics are increased if the doped nitrogen is more than a prescribed concentration, and thereby completed the present invention.

Also, the present inventors discovered that, in order that defects of the epitaxial surface layer should not be produced, it is necessary to consider the nitrogen concentration and oxygen concentration in relation to each other, such that, while the nitrogen concentration may be high if the oxygen concentration is low, on the other hand, if the oxygen concentration is high, the nitrogen concentration must be made low in order to prevent production of defects in the epitaxial surface layer.

More specifically, according to the present invention there are provided a wafer and a method as follows.

An epitaxial silicon wafer wherein an epitaxial film is formed on a silicon wafer substrate doped with nitrogen and wherein hill-shaped defects are not observed on the epitaxial film.

An epitaxial silicon wafer wherein an epitaxial film is formed on a silicon wafer substrate doped with nitrogen and wherein the number of crystal defects observed as LPDs of 120 nm or more on the epitaxial film is 20 pieces/200-mm wafer or less.

A method of manufacturing a silicon single crystal ingot by the Czochralski method, characterized in that the silicon single crystal pulling is performed whilst doping with nitrogen in a region wherein the number of crystal defects observed after epitaxial growth as LPDs of 120 nm or more is 20 pieces/200-mm wafer or less.

A method of manufacturing a silicon single crystal ingot by the Czochralski method, characterized in that the silicon single crystal pulling is performed in a range of nitrogen concentration and oxygen concentration not exceeding a range wherein the nitrogen concentration when the oxygen concentration is 7 X 10¹⁷ atoms/cm³ is about 3 X 10¹⁵ atoms/cm³ and the nitrogen concentration when the oxygen concentration is 1.6 X 10¹⁸ atoms/cm³ is about 3 X 10¹⁴ atoms/cm³.

The method of manufacturing a silicon single crystal ingot by the Czochralski method according to claim 4, characterized in that the oxygen concentration is lowered in accordance with increase in nitrogen concentration.

A nitrogen-doped silicon wafer wherein the nitrogen concentration and oxygen concentration are within a range of nitrogen concentration when the oxygen concentration is 7 X 10¹⁷ atoms/cm³ being about 3 X 10¹⁵ atoms/cm³ or less and nitrogen concentration when the oxygen concentration is 1.6 X 10¹⁸ atoms/cm³ being about 3 X 10¹⁴ atoms/cm³ or less.

A nitrogen-doped silicon wafer wherein the nitrogen concentration and oxygen concentration are within a range of nitrogen concentration when the oxygen concentration is 7 X 10¹⁷ atoms/cm³ being about 1 X 10¹⁵ atoms/cm³ or less and nitrogen concentration when the oxygen concentration is 1.5 X 10¹⁸ atoms/cm³ being about 1 X 10¹⁴ atoms/cm³ or less.

A silicon ingot wherein the nitrogen concentration of the terminal end of the straight body section is in a range of from 1 X 10¹⁵ atoms/cm³ to 3 X 10¹⁵ atoms/cm³.

The silicon ingot according to (8) above, wherein the oxygen concentration in this silicon ingot is suitably controlled in accordance with changes in the nitrogen concentration in this silicon ingot.

While a nitrogen-doped silicon wafer cannot be said to have performance suited to use as a product as it is, an epitaxial silicon wafer wherein the nitrogen concentration and oxygen concentration of the silicon wafer substrate are adjusted within the aforementioned range is suited to use as a product in that defects of the surface layer which would have an adverse effect on the device performance are absent or extremely few.

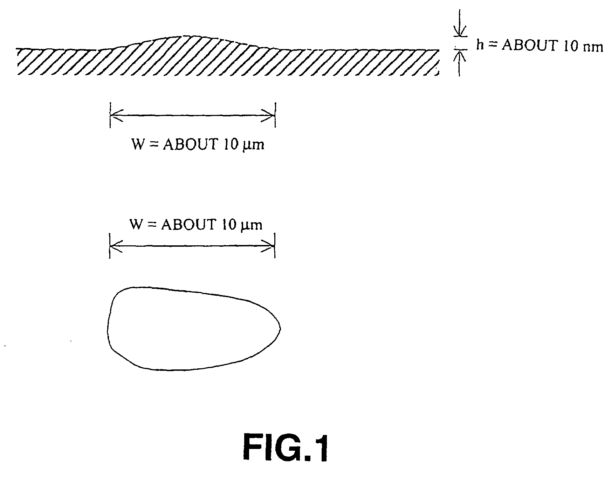

According to the investigations of the present inventors, the defects appearing in the surface layer of an epitaxial silicon wafer obtained by epitaxial precipitation on a silicon wafer substrate doped with nitrogen are hill-shaped defects of height about 10 nm and width about 10 µm (observation using AFM) as shown in Figure 1. These hill-shaped defects, which are referred to in the present specification as "hill-shaped defects", are actually observed as LPDs (Light Point Defects) at the epitaxial wafer surface; thus, these hill-shaped defects are included as some of the defects observed as LPDs.

It should be noted that, if the nitrogen concentration/oxygen concentration is too small, this causes lowered heavy-metal capturing ability due to decrease of the gettering sites; the quantity of gettering sites to be set can be suitably determined by a person skilled in the art in accordance with the type of intended product, by suitably adjusting the nitrogen concentration/oxygen concentration.

### BRIEF DESCRIPTION OF THE DRAWINGS

Figure 1 is a view illustrating the shape of a "hill-shaped defect" discovered by the present inventors;
Figure 2 is a view illustrating the change of nitrogen concentration and the change of oxygen concentration in a silicon ingot during crystal growth;
Figure 3 is a graph plotting the relationship between nitrogen concentration and LPDs (Light Point Defects); and
Figure 4 is a graph plotting the relationship between nitrogen concentration and oxygen concentration.

### BEST MODE FOR CARRYING OUT THE INVENTION

As a first embodiment of the present invention, a silicon wafer substrate is manufactured by the Czochralski method (CZ method). In this embodiment, by the Czochralski method, a silicon single crystal is doped with nitrogen and pulled up to manufacture a silicon ingot; after this, the portions thereof whose nitrogen concentration and oxygen concentration are within the aforesaid range are cut out and used as silicon wafer substrates. When using the CZ method, a method in which a magnetic field is applied to the melt (MCZ method) may also be adopted.

As the method of nitrogen doping, all methods that are currently known, such as the method of admixing nitrogen with the argon gas that is passed through the furnace when growing the crystal or the method of introducing nitrogen atoms into the pulled single crystal by dissolving silicon nitride in the raw-material melt and all methods that may in future be discovered can be employed.

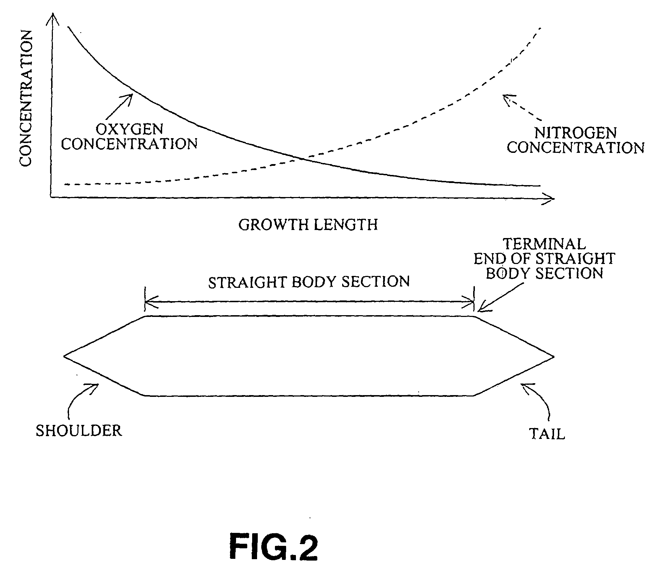

When the silicon ingot is pulled from the silicon melt, unless the oxygen concentration, etc., is deliberately controlled, fluctuation of the nitrogen concentration caused by nitrogen segregation and fluctuation of the incorporated oxygen concentration are produced in the manner as shown in Figure 2. Specifically, the nitrogen concentration shows a gradual continuous increase from first pulling (the shoulder portion) to the terminal end (tail portion), whereas the oxygen concentration shows a gradual decrease.

Consequently, by setting the nitrogen concentration in the terminal end of the straight body section, where nitrogen concentration shows maximum throughout the regions from which the product is taken, to the upper limit of the aforesaid nitrogen concentration, it is possible to ensure that the silicon concentration in the entire silicon ingot is less than 3 X 10¹⁵ atoms/cm³. By suitably controlling the oxygen concentration in the silicon ingot in accordance with the change in nitrogen concentration such that the oxygen concentration and nitrogen concentration are within the range indicated in (6) above, it is possible for this silicon ingot into a silicon ingot wherein the entire straight body portion can be utilized as the region from which the product can be taken, with no formation of wasted portions in the straight body portion of the silicon ingot thus pulled.

In this case, the oxygen concentration can be, comparatively speaking, more freely set than the nitrogen concentration. Therefore, control of the oxygen concentration may be performed so as to produce a silicon ingot for efficient use of the straight body portion wherein practically the entire straight body portion thereof constitutes a region that can be used for manufacture of silicon wafers, or suitable control of the oxygen concentration may be performed in accordance with the oxygen concentration/nitrogen concentration of the wafer substrate to be obtained.

As an example of experiments, silicon wafers were cut from a CZ-Si single crystal grown under various conditions and epitaxial growth was performed thereon after processing by specular grinding, and then the behavior of oxygen precipitation on the epitaxial substrate and defects of the epitaxial surface layer were studied.

In the example of the experiments, the crystal was of diameter 200 mm, p type, crystal orientation <100> with boron added as dopant; the oxygen concentration was controlled so as to be 8 X 10¹⁷ to 16 X 10¹⁷ atoms/cm³ and nitrogen was added to give a nitrogen concentration of 4.9 X 10¹³ to 1.24 X 10¹⁵ atoms/cm³; for comparison, crystal was also prepared with no nitrogen addition. Epitaxial growth was performed using trichlorosilane as the gas for epitaxial growth, a growth temperature of 1100°C and epitaxial film thickness of 6 µm.

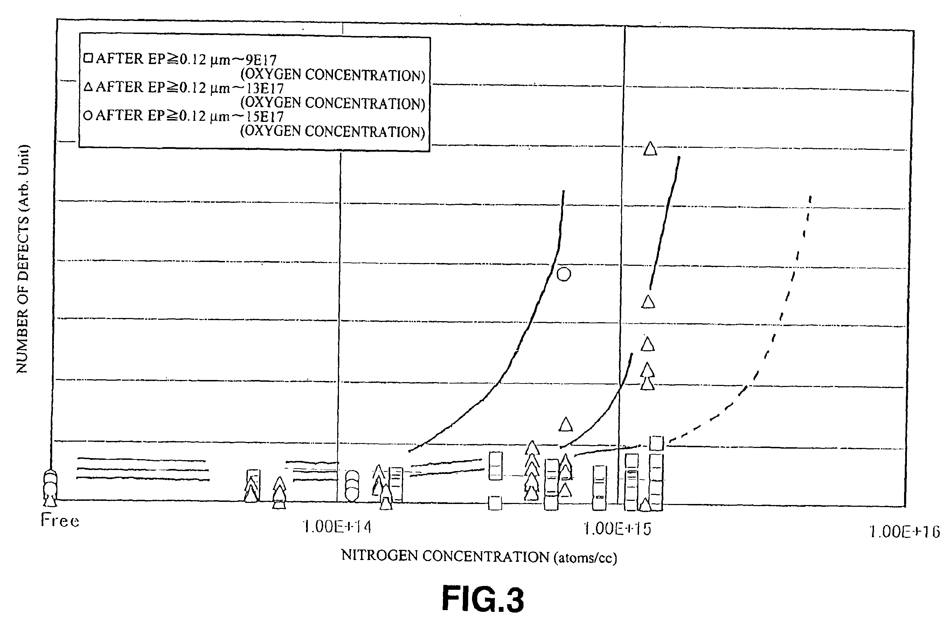

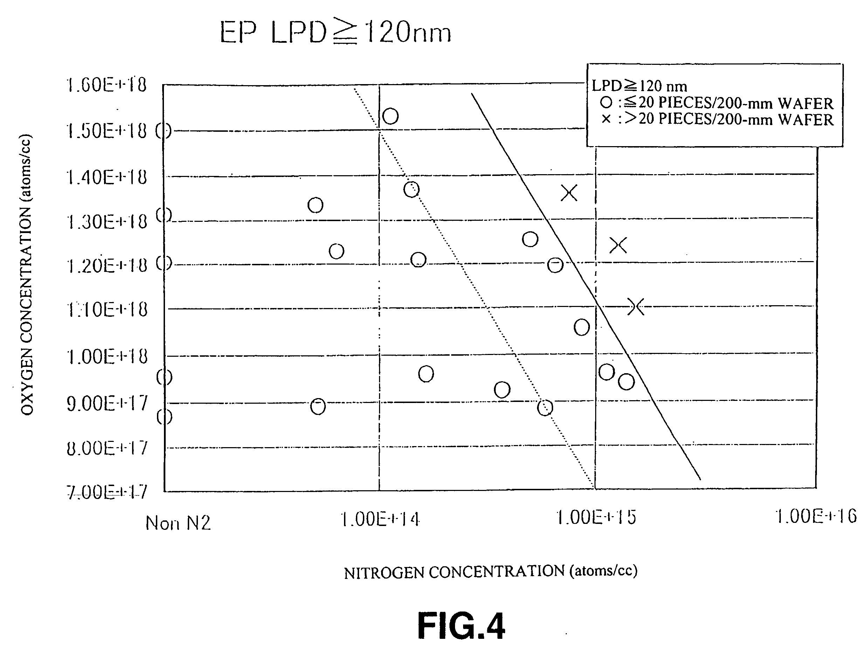

The results are shown in Figure 3 and Figure 4. Figure 3 shows the relationship between the nitrogen concentration and the number of defects generated (number of defects observed as LPDs) and Figure 4 shows the relationship between the nitrogen concentration and the oxygen concentration, for the same data.

First of all, from Figure 3, it can be seen that, when the oxygen concentration is low, even if the nitrogen concentration is comparatively high, the number of defects is not greatly increased; however, when the oxygen concentration is high, the number of defects becomes large when the nitrogen concentration increases. Figure 3 therefore suggests that there is a prescribed correlative relationship between the oxygen concentration and nitrogen concentration, such as that the nitrogen concentration must be made low if the oxygen concentration is high.

Also, from Figure 4, in which the oxygen concentration and nitrogen concentration are plotted along the horizontal axis and vertical axis, respectively, it is clear that there is a prescribed correlative relationship between the oxygen concentration and nitrogen concentration.

If the criteria for determining whether or not the wafer is suitable for use as a product is set as the number of LPD (of 0.12 µm or more) per 200-mm wafer being 20 or less, Figure 4 suggests that the boundary line is the line joining points, (oxygen concentration, nitrogen concentration) = (7 X 10¹⁷ atoms/cm³, about 3 X 10¹⁵ atoms/cm³) and (oxygen concentration, nitrogen concentration) = (1.6 X 10¹⁸ atoms/cm^{3,} about 3 X 10¹⁴ atoms/cm³) (inclined olid line in Figure 4). Also, if a stricter criteria is set for use as a product, it suggests that the boundary line is the line (dotted line in Figure 4) joining points, (oxygen concentration, nitrogen concentration) = (7 X 10¹⁷ atoms/cm³, about 1 X 10¹⁵ atoms/cm³) and (oxygen concentration, nitrogen concentration) = (1.5 X 10¹⁸ atoms/cm^{3,} about 1 X 10¹⁴ atoms/cm³). Whatever the case, since the above discussion is based on the range of data obtained currently, some degree of variation in the numerical values should be allowed.

Consequently, as seen from this Figure 4, in order to manufacture nitrogen doped silicon wafer substrates suitable for manufacturing epitaxial silicon wafers, the silicon single crystal pulling should be performed on the left-hand side of the solid line (more specifically, in a range in which the nitrogen concentration when the oxygen concentration is 7 X 10¹⁷ atoms/cm³ is about 3 X 10¹⁵ atoms/cm³ or less and the nitrogen concentration when the oxygen concentration is 1.6 X 10¹⁸ atoms/cm³ is about 3 X 10¹⁴ atoms/cm³ or less). Also, preferably, the silicon single crystal pulling may be performed on the left-hand side of the dotted line (more specifically, in a range in which the nitrogen concentration when the oxygen concentration is 7 X 10¹⁷ atoms/cm³ is not more than about 1 X 10¹⁵ atoms/cm³ and the nitrogen concentration when the oxygen concentration is 1.5 X 10¹⁸ atoms/cm³ is about 1 X 10¹⁴ atoms/cm³ or less).

It should be noted that, regarding the lower limit of oxygen concentration and nitrogen concentration, the lower limiting value of the amount of added nitrogen, which is a function of the initial oxygen concentration of the silicon wafer substrate, can be determined such as to ensure a sufficient density of oxygen precipitates as gettering sites, depending on a desired product.

### INDUSTRIAL APPLICABILITY

As described above, a silicon wafer in accordance with the present invention has excellent properties that are uninfluenced by surface layer defects that adversely affect device performance. That is, products in which an epitaxial film is grown on a silicon wafer manufactured under the conditions of the present invention have excellent properties in use in advanced semiconductor devices.

Also, by suitably setting the conditions, a nitrogen-doped epitaxial silicon wafer can be manufactured having a high gettering capability, since gettering sites are not lost.

## Claims

1. An epitaxial silicon wafer including a silicon wafer substrate doped with nitrogen on which an epitaxial film formed, wherein a hill-shaped defect is not observed on the epitaxial film.

2. An epitaxial silicon wafer including a silicon wafer substrate doped with nitrogen on which an epitaxial film formed, wherein the number of crystal defects observed as LPDs of 120 nm or more on the epitaxial film is 20 pieces/200-mm wafer or less.

3. A method of manufacturing a silicon single crystal ingot by Czochralski method, wherein silicon single crystal pulling is performed while nitrogen is being doped in a region where the number of crystal defects observed after epitaxial growth as LPDs of 120 nm or more is 20 pieces/200-mm wafer or less.

4. A method of manufacturing a silicon single crystal ingot by Czochralski method, wherein silicon single crystal pulling is performed in a range of nitrogen concentration and oxygen concentration not exceeding a range wherein the nitrogen concentration is about 3 X 10¹⁵ atoms/cm³ when the oxygen concentration is 7 X 10¹⁷ atoms/cm³ and the nitrogen concentration is about 3 X 10¹⁴ atoms/cm³ when the oxygen concentration is 1.6 X 10¹⁸ atoms/cm³.

5. The method of manufacturing a silicon single crystal ingot by the Czochralski method according to claim 4, wherein the oxygen concentration is lowered corresponding to an in accordance with increase in nitrogen concentration.

6. A nitrogen-doped silicon wafer, wherein nitrogen concentration and oxygen concentration are within a range in which the nitrogen concentration is about 3 X 10¹⁵ atoms/cm³ or less when the oxygen concentration is 7 X 10¹⁷ atoms/cm³ and the nitrogen concentration is about 3 X 10¹⁴ atoms/cm³ or less when the oxygen concentration is 1.6 X 10¹⁸ atoms/cm³.

7. A nitrogen-doped silicon wafer, wherein nitrogen concentration and oxygen concentration are within a range in which the nitrogen concentration is about 1 X 10¹⁵ atoms/cm³ or less when the oxygen concentration is 7 X 10¹⁷ atoms/cm³ and the nitrogen concentration is about 1 X 10¹⁴ atoms/cm³ or less when the oxygen concentration is 1.5 X 10¹⁸ atoms/cm³.

8. A silicon ingot, wherein nitrogen concentration of a terminal end of a straight body section of the silicon ingot is in a range of from 1 X 10¹⁵ atoms/cm³ to 3 X 10¹⁵ atoms/cm³.

9. The silicon ingot according to claim 8, wherein oxygen concentration in the silicon ingot is controlled corresponding to a change in the nitrogen concentration in the silicon ingot.
